Europäisches Patentamt

European Patent Office

Office européen des brevets

(19)

(11) Publication number: **0 009 370**
**A1**

(12)

# EUROPEAN PATENT APPLICATION

(21) Application number: **79301879.7**

(22) Date of filing: **13.09.79**

(51) Int. Cl.³: **H 03 K 17/687,** H 03 K 17/64, H 05 B 37/02, B 60 Q 1/26

(30) Priority: **21.09.78 GB 3755578**
**19.10.78 GB 4112478**

(43) Date of publication of application: **02.04.80**
**Bulletin 80/7**

(84) Designated Contracting States: **AT BE CH DE FR GB IT LU NL SE**

(71) Applicant: **WARD & GOLDSTONE LIMITED, Frederick Road, Salford, M6 6AP (GB)**

(72) Inventor: **Hampshire, Michael John, 792 Halifax Road, Liversedge West Yorkshire (GB)**

(74) Representative: **Downey, William Gerrard WILSON GUNN & ELLIS et al, 41 Royal Exchange Cross Street, Manchester, M2 7DB (GB)**

(54) An electronic switch and method of operating it.

(57) An electronic switch comprises a p-channel vertical-metal oxidesilicon (VMOS) power device (32) having a substantially linear input voltage/output current relationship which is used to switch the supply to the tail/brake lamp (33) of a vehicle. Three different inputs (In3, In2 and In1) to the gate (G) of the device are provided. Due to resistor means (34) these inputs have resistances appropriate to three different lamp current levels ($I_3$, $I_2$, $I_1$, resp. $I_4$) in the lamp respectively corresponding to just insufficient to illuminate, illumination at a first light level for a tail lamp function and illumination at a second light level for a stop lamp function. The lamp is normally off with current therein at the first current level ($I_3$). This reduces time delay to illumination and current surge on illumination. After switching to current level $I_1$ the filament temperature of the bulb (33) rises and becomes more resistive. Hence the lamp current changes from value $I_1$ to value $I_4$. A diode across the lamp filament reduces back emfs generated on reducing the current.

-1-

# AN ELECTRONIC SWITCH AND METHOD OF OPERATING IT

This invention relates to the switching of electrical loads in a vehicle. Hitherto electrical loads have been switched by mechanical means either electrically or manually operated, however, with the advent of electronic control of switching functions it is appropriate that electronic means using solid state devices be used. There are three main problems associated with the switching of loads. Firstly supplying power to an incandescent lamp such as a tungsten filament bulb causes problems because of the very low electrical resistance of the filament when at ambient temperature, because a very high surge current flows when connection is made to a voltage source. Secondly large back emfs may be produced when breaking the current in inductive circuits, and the back emf is a source of interference to electronics installed in the vehicle. Thirdly there is the problem of providing protection of the switch and circuitry against possible short circuit loads; hitherto this has been achieved by the use of fuses.

In the particular case of vehicle lamps, in the non-

-2-

illuminating or off state, the lamp filament bulbs, and more particularly the filaments themselves are at ambient temperature. Consequently, due to the resistance/temperature characteristic of the material of the filament on connection to the power supply, the initial resistance presented by the filament is very low resulting in a high surge of current. The time taken for the filament to reach its full operating temperature depends on the value of the surge current which may be limited by the output resistance of the supply. Typically for a 12V, 22W filament bulb the resistance at ambient temperature is $0.6\Omega$ and a surge current of 20A would be expected from a 12V supply. The output resistance resulting from wires, connections and contacts can typically be $2\Omega$ or thereabouts, and this results in a time delay in excess of 30 ms before full illumination is achieved due to the thermal capacity of the filament. The surge current resulting from the low ambient resistance of the filament in a given bulb will cause a large drop in voltage which is a very serious source of electrical noise and would be detrimental to the operation of electronics sharing a power supply with the bulb. Where two levels of illumination are required for different functions such as rear lights and stop lights, it is common practice to house two separately fed filaments, one rated at 6W and the other at 22W in one bulb.

According to one aspect of the present invention, there

-3-

is provided, a circuit comprising a solid state power switch and a load, the solid state power switch having a smoothly varying input voltage/output current relationship characterised by impedance means connected to the input of the power switch for selectively varying the input voltage in order to vary the output current.

According to another aspect of the present invention, there is provided a circuit comprising a solid state power switch and an inductive load, the solid state power switch having a smoothly varying input voltage output current relationship characterised in that two impedances respectively having time constants to limit the rate of rise of the input voltage and to limit the rate of fall of the input voltage to the switch are connected to the input to the switch whereby to control the rate of rise and rate of fall of the output current to limit the magnitude of back emfs produced by changing current in the inductive load.

According to a further aspect of the present invention, there is provided a method of operating a filament lamp in which the lamp is supplied with a current just below a threshold value necessary to cause emission of light whereby, when the lamp is supplied with a current sufficient to cause emission of light, the current surge which would otherwise be produced on switching on the lamp is
reduced.

A preferred embodiment of the invention may comprise
any one or more of the following advantageous features:-

(a)   The solid state power switch is a vertical-metal
      oxide-silicon (VMOS) power device.

(b)   The VMOS device of (a) is p-channel.

(c)   The input voltage/output current relationship
      is substantially linear.

(d)   The load is a filament of a bulb.

(e)   The bulb is the tail lamp bulb of a vehicle.

The invention also comprises a vehicle having a load
such as a lamp, for example, controlled by a switching cir-
cuit as defined above.

In order that the invention may be more clearly understood, two embodiments of the invention will now be described,
by way of example, with reference to the accompanying drawings, in which:-

Figure 1 shows a circuit comprising a p-channel vertical metal oxide semiconductor,

Figure 2 shows the operating characteristic of a vertical metal oxide semiconductor of the type forming part of
the circuit of Figure 1,

Figure 3 shows a circuit diagram of a power supply
circuit for a rear/stop lamp for a vehicle, and

Figure 4 shows the input voltage/drain current relationship for a power switch forming part of the circuit of Figure
3.

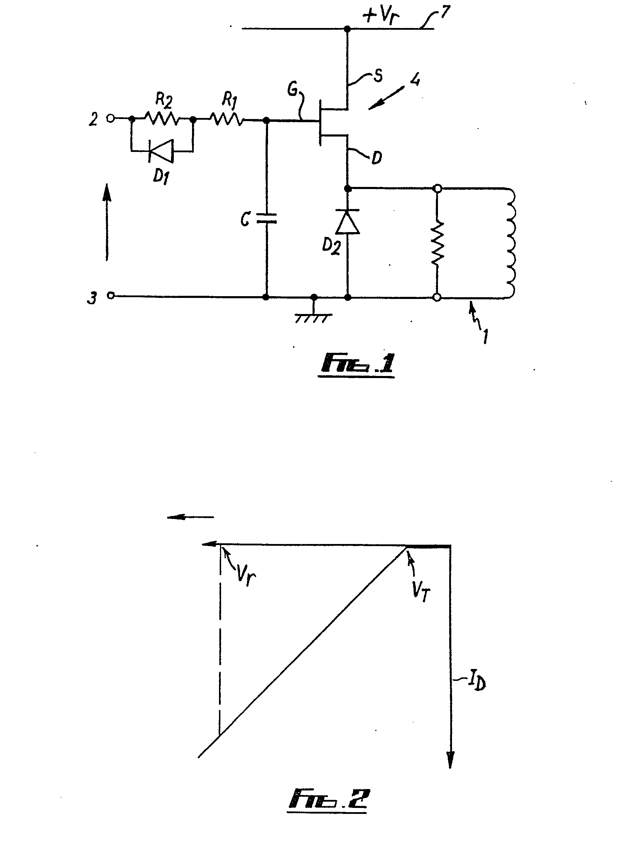

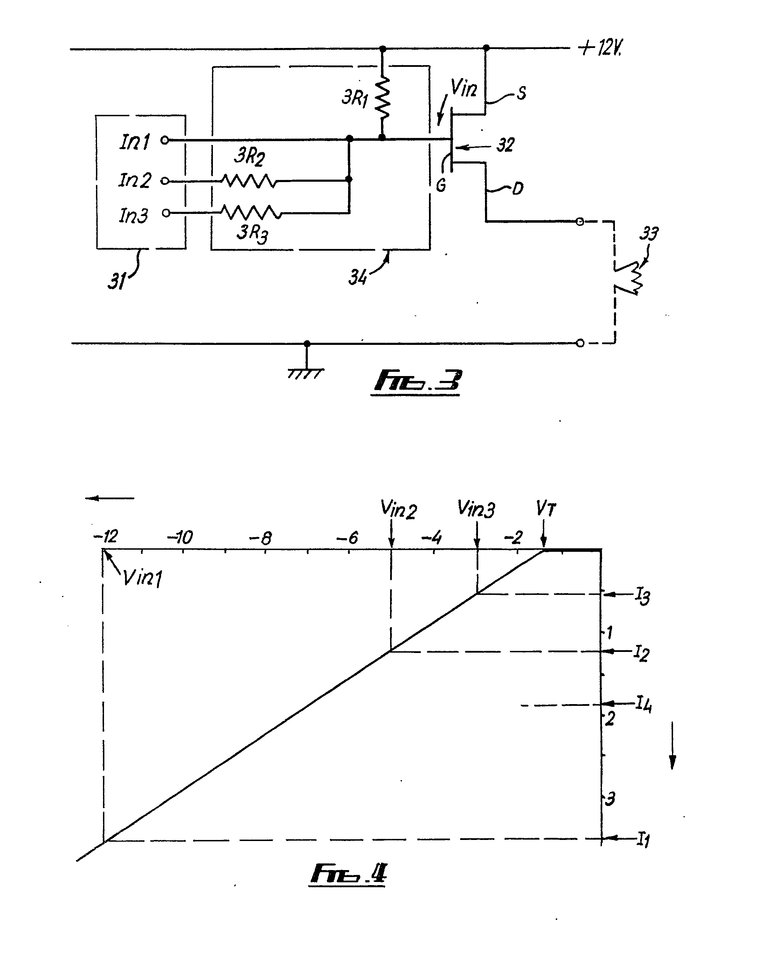

Referring to Figure 1, a load 1 is fed from a supply
through terminals 3 and 7. This load is switched on and
off by means of a switch 4 comprising a p-channel vertical
metal oxide semiconductor device which has an operating
characteristic as shown in Figure 2. Such devices are
complementary versions of n-channel VMOS devices produced,
for example, by Siliconex Incorporated and described in
their VMOS Power Fets Design Catalog.

The switch 4 is a current generator having a gate/source
threshold turn on voltage of $V_T$ and a subsequent substantially linear relationship between the gate/source voltage
($V_{GS}$, plotted on Figure 2 as abscissa) and the drain current ($I_D$ plotted on Figure 2 as ordinate). The gate electrode G of the switch 4 is connected through a parallel con-
nection of a resistor $R_2$ and diode $D_1$ in series with a fur-

ther resistor $R_1$ to the terminal 2, the source electrode
S is connected to the positive rail having a voltage $V_R$
and the drain electrode D is connected to earth <u>via</u>
a diode $D_2$ which is connected in parallel with the load.
A capacitor C is connected between the gate of the VMOS
device and ground.

The current through the load 1 is determined by
$V_{GS}$ according to the characteristic in Figure 2, unless the
device is saturated in which case the current in the load
is determined by $(V_r - V_{DS\ SAT})/R_L$ where $V_{DS\ SAT}$ is the
saturation voltage between source S and drain D. The rate
of rise of the output current is determined by the time
constant $R_1C$ as the input resistance of the V.M.O.S. device 4 is almost infinite, whilst the rate of fall of the
current is determined by the time constant $(R_2 + R_1)C$ because
diode $D_1$ is reverse biassed during turn off when the input
voltage rises. The diode $D_2$ connected across the load is
to minimise further the back emf arising from reducing the
current in the inductive loads. If the input voltage across
terminals 2 and 3 rises, so that $V_{GS}$ lies within the threshold voltage, $V_T$ of the top rail voltage $V_r$, then no current
flows and the switch 4 is in the off state.

The above described arrangement provides a solid state
switch which is capable of supplying current to incandescent
filament bulbs, which is capable of turning off inductive
loads without ecessive back emfs being generated, and which
will provide protection against the advent of a short cir- cuit load.

Figure 3 shows a circuit specifically for a vehicle tail lamp. The circuit basically comprises input terminal means 31, switch means 32, a filament bulb 33 and resistor means 34. The input terminal means 31 consists of three separate inputs In1, In2, In3 any of which may be activated by grounding the appropriate terminal. When not activated, a given input is at +12V. The switch means 32 consists of a p-channel vertical-metal-oxide-silicon (VMOS) power device having a characteristic as shown in Figure 4. This characteristic is the same as that shown in Figure 2, but specific values relating to this particular embodiment have been shown on it. The device is complementary to the n-channel VMOS devices presently manufactured by Siliconex Ltd. As shown in Figure 4 (and also in Figure 2) electrical characteristics of the power switch are such that the output current is dependent upon the input voltage in an approximately linear manner, such that the current in the filament of the bulb 33 is determined either by the magnitude of the input voltage or by the resistance of the filament, whichever produces the least current. The drain current from the switch 32 is fed via the filament bulb 33 to ground. The input voltage $V_{in}$ is defined as the gate voltage relative to the source voltage, and is determined by the resistor means 34 and the voltages present at the input means 31. The resistor means 34 comprises three resistors $3R_1$, $3R_2$ and $3R_3$. In Figure 3 gate, source and drain electrodes of the switch 32 are respectively referenced G, S and D as in Figure 1.

When the input In3 is activated by grounding that particular input the resistors $3R_1$ and $3R_3$ of the resistor 34 determine a value of the input voltage $V_{in}$, of $V_{in3}$, and a corresponding current $I_3$ in the filament is produced as shown in Figure 4. $I_3$ is the maximum threshold current above which the filament of the bulb 33 begins to emit light.

When input In2 is activated, the resistors $3R_1$ and $3R_2$ of the resistor means 34 determine an input voltage $V_{in2}$ which results in a current I2, producing a low level of illumination appropriate to a rear side light; see Figure 4.

When input In1 is activated, the full 12V appears at the input $V_{in1}$, which can generate a surge current $I_1$. However, as the filament temperature rises and becomes more resistive the switch 32 saturates and the current settles to a value $I_4$ which is determined by the resistance of the filament; see Figure 4. $I_4$ is appropriate to the maximum illumination from the filament and serves typically as a stop light for the vehicle.

The above described arrangement enables:-

(i)  the time delay in achieving full illumination to

0009370

be substantially reduced.

(ii) the current surge on switch on and the electrical noise associated with it to be substantially reduced.

(iii) one or more levels of light output from a given filament to be achieved.

It will be appreciated that the above described arrangement has been described by way of example only and that many variations are possible without departing from the scope of the invention.

0009370

CLAIMS

1.  A circuit comprising a solid state power switch and a
load, the solid state power switch having a smoothly varying input voltage/output current relationship characterised
by impedance means connected to the input of the power
switch for selectively varying the input voltage in order
to vary the output current.

2.  A circuit comprising a solid state power switch and an
inductive load, the solid state power switch having a smoothly
varying input voltage output current relationship character-
ised in that two impedances respectively having time constants to limit the rate of rise of the input voltage and to
limit the rate of fall of the input voltage to the switch
are connected to the input to the switch whereby to control
the rate of rise and rate of fall of the output current to
limit the magnitude of back emfs produced by changing current in the inductive load.

3.  A circuit as claimed in Claim 1 or 2, characterised in
that the solid state power switch is a vertical metal oxide-
silicon (VMOS) power device.

4.  A circuit as claimed in Claim 3, characterised in that
the VMOS device is p-channel.

5.  A circuit as claimed in any preceding claim, character- ised in that the input voltage/output current relationship is substantially linear.

6. A circuit as claimed in any preceding claim, characterised in that the load is a filament of a bulb.

7. A circuit as claimed in Claim 6, characterised in that the bulb is the tail brake lamp of a vehicle.

8. A vehicle characterised by a circuit as claimed in any preceding claim.

9. A method of operating a filament lamp in which the lamp is supplied with a current just below a threshold value necessary to cause emission of light whereby, when the lamp is supplied with a current sufficient to cause emission of light, the current surge which would otherwise be produced on switching on the lamp is reduced.

0009370

Fig.1

Fig.2

_Fig.3_

_Fig.4_

European Patent
Office

**EUROPEAN SEARCH REPORT**

0009370
Application number

EP 79 3C1 879.7

| Category | DOCUMENTS CONSIDERED TO·BE RELEVANT<br>Citation of document with indication, where appropriate, of relevant passages | Relevant to claim | CLASSIFICATION OF THE APPLICATION (Int. Cl.³) |
|---|---|---|---|
| X | BAUELEMENTE DER ELEKTROTECHNIK, Vol. 13, No. 2, 1978<br>Wiesbaden<br>"Leistungs-MOS-FET im TO-202-Plastik-gehäuse" and "Applikationsbeispiele für die MOS-FET"<br>pages 56, 58, 59<br>* page 56, circuit: TTL programmable current sink, positions: $R_1$, $Rp_1$ ... $Rp_4$; page 56, circuit: High efficiency light dimmer * | 1,3,5<br><br>1,3,5,<br>6 | H 03 K 17/687<br>H 03 K 17/64<br>H 05 B 37/02<br>B 60 Q 1/26 |
| | -- | | |
| X | ELEKTRONIKPRAXIS, Vol. 6, No. 7/8, August 1971<br>Würzburg<br>"Glühlämpchen als Störungsquelle in logischen Schaltungen"<br>page 12<br>* complete article * | 9 | **TECHNICAL FIELDS SEARCHED (Int.Cl.³)**<br><br>B 60 Q 1/00<br>H 03 K 17/00<br>H 05 B 37/00<br>H 05 B 39/00 |
| | -- | | |
| | ELECTRONICS, 24 June 1976<br>New York<br>M. VANDER KOOI et al. "MOS moves into higher-power applications"<br>pages 98 to 103<br>* page 99, column 2, lines 12 to 14, page 99, circuit 3c * | 5<br>3,5,6 | |
| | --<br>./.. | | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons
&: member of the same patent family, corresponding document

| X | The present search report has been drawn up for all claims | | |
|---|---|---|---|
| Place of search<br>Berlin | Date of completion of the search<br>27-11-1979 | Examiner<br>ARENDT | |

## DOCUMENTS CONSIDERED TO BE RELEVANT

| Category | Citation of document with indication, where appropriate, of relevant passages | Relevant to claim |
|---|---|---|
| | ELECTRONIQUE ET APPLICATIONS INDUSTRIEL-LES, No. 241, October 1977 L. PIERRE "Pourquoi ne pas utiliser des VMOS?" pages 16 to 17 | |
| | * page 17, circuit 4; | 2,3,5 |
| | page 17, circuit 2; | 3,5,6 |
| | page 17, column 3, lines 7 to 10; | 8 |
| | page 17, column 3, lines 13 to 19 * | 4 |
| | -- | |
| A | US – A – 3 597 634 (GEBRÜDER JUNGHANS GMBH) | |
| | * fig. 1, positions: R,C ; fig. 5 and 6 * | 2 |
| | -- | |
| A | DE – A – 2 014 546 (J. LUCAS) | |
| | * claims 1 and 2 * | |
| | -- | |
| A | COMPUTER DESIGN Vol. 16, No. 12 December 1977 L. SHAEFFER, "VMOS peripheral drivers solve high power load interface problems" pages 90, 94, 96 to 98 * complete document * | |
| | -- | |
| | ./.. | |

CLASSIFICATION OF THE APPLICATION (Int. Cl.3)

TECHNICAL FIELDS SEARCHED (Int. Cl.3)

EPO Form 1503.2  06.78

European Patent Office

**EUROPEAN SEARCH REPORT**

0009370

Application number

EP 79 301 879.7

- page 3 -

## DOCUMENTS CONSIDERED TO BE RELEVANT

| Category | Citation of document with indication, where appropriate, of relevant passages | Relevant to claim |
|---|---|---|
| A | ELECTRONIC DESIGN, Vol. 15, 19 July 1977, New York  "Don't trade off analog-switch specs."  pages 56 to 61  * complete article *  ---- | |

CLASSIFICATION OF THE APPLICATION (Int. Cl.)

TECHNICAL FIELDS SEARCHED (Int. Cl.)